**Europäisches Patentamt**

**European Patent Office**

**Office européen des brevets**

(19)

(11) Veröffentlichungsnummer: **0 228 558**
**B1**

(12) **EUROPÄISCHE PATENTSCHRIFT**

(45) Veröffentlichungstag der Patentschrift: **20.06.90**

(21) Anmeldenummer: **86116128.9**

(22) Anmeldetag: **21.11.86**

(51) Int. Cl.⁵: **F 23 N 5/08,** H 03 K 5/01,
G 01 R 15/00

(54) **Schaltungsanordnung zur selektiven Flammenüberwachung in Mehrbrenneranlagen.**

(30) Priorität: **23.12.85 DD 285177**

(43) Veröffentlichungstag der Anmeldung:
**15.07.87 Patentblatt 87/29**

(45) Bekanntmachung des Hinweises auf die
Patenterteilung:
**20.06.90 Patentblatt 90/25**

(84) Benannte Vertragsstaaten:
**AT CH DE FR LI**

(56) Entgegenhaltungen:
DE-A-2 413 482
GB-A-2 091 964

PATENT ABSTRACTS OF JAPAN, Band 9, Nr.
150 (E-324)1873r, 25. Juni 1985; & JP-A-60 30
224 (SANYO DENKI K.K.) 15-02-1985
ELECTRONIC DESIGN, Band 30, Nr. 9, April
1982, Seiten 215,216, Denville, NJ, US; J.P.
OEHMICHEN: "Two-chip discriminator monitors
frequency window"

(73) Patentinhaber: **VEB Geräte- und Regler-Werk
Leipzig
Baalsdorfer Strasse 55
DDR-7027 Leipzig (DD)**

(72) Erfinder: **Podbielski, Martin
Ringstrasse 12
DDR-Torgau 7290 (DD)**
Erfinder: **Ceschia, Michael, Dipl.-Ing.
Bruno-Leuschner-Strasse 35
DDR-7025 Leipzig (DD)**

(74) Vertreter: **Patentanwälte Beetz sen. - Beetz jun.
Timpe - Siegfried - Schmitt-Fumian
Steinsdorfstrasse 10
D-8000 München 22 (DE)**

(56) Entgegenhaltungen:
E.D.N. ELECTRICAL DESIGN NEWS, Band 26, Nr.
24, Dezember 1981, Seite 373, Boston, Mass.,
US; R.J. LAVERY: "1 1/2 ICs provide frequency
comparisons"

E.D.N. ELECTRICAL DESIGN NEWS, Band 26, Nr.
2, 2. Januar 1981, Seiten 148,150, Boston, Mass.,
US; J. DUNN: "One-shots detect frequency
levels"

## Beschreibung

Die Erfindung betrifft eine Schaltungsanordnung zur selektiven Flammenüberwachung in Mehrbrenneranlagen für feste, flüssige oder gasförmige Brennstoffe, die aus einer optoelektronischen Fühlereinheit besteht, bei der das optoelektronische Fühlerelement über einem Kondensator mit einem Impulsformer, der eine der Flackherfrequenz der Flamme entsprechende Impulsfolge erzeugt verbunden ist, einer elektronischen Auswerte und Schalteinheit.

Mehrbrenneranlagen werden über eine Anzahl von einzelnen Brennern betrieben, die in einen gemeinsamen Verbrennungsraum einstrahlen. Die besondere Aufgabe einer selektiven Flammenüberwachung in diesen Anlagen besteht darin, daß die einzelnen Brennerflammen getrennt, d.h. unabhängig von dem Zustand "Flamme ein" oder "Flamme aus" der übrigen Brenner, erfaßt werden müssen, um bei Flammenausfall zur Vermeidung gefährlicher Brennstoffkonzentrationen die Brennstoffzufuhr für den betreffenden Brenner sofort zu stoppen. Als Problem stellt sich dar, daß die zur Über-wachung der Flamme eingesetzten Fühler-elemente auch Fremdsignale aufnehmen, die nach Verlöschen der Flamme durch Schlierenbildung an den nachglühenden Teilen im Feuerraum (Hintergrundstrahlung) bzw. durch zeitweise eingestrahlte Flammenspitzen benachbarter Brennerflammen entstehen. Um zu verhindern, daß diese Fremdsignale bei fehlender Flamme weitergeleitet und als Zustand "Flamme vorhanden" bewertet werden (Flammenvortäuschung), sind besondere Maßnahmen erforderlich. Dabei wird die Tatsache genutzt, daß als Folge der bei einer Verbrennung ablaufenden Reaktionen die Flamme einen um den Mittelwert der Strahlungsintensität schwankenden, impulsartigen Strahlungsanteil aussendet, der entlang des Flammenweges in der Impulsfolge (Flackerfrequenz) unterschliedliche Größen aufweist. In der Praxis haben die aus dem Flammenkern abgestrahlten Signale eine im Vergleich zu anderen Abschnitten der Flamme und gegenüber der Hintergrundstrahlung deutlich höhere Frequenz, jedoch geringere Amplitude. Eine selektive Überwachung erfolgt allgemein in der Weise, daß das Fühlerelement auf einen bestimmten Flammenabschnitt der zu überwachenden Brennerflamme ausgerichtet wird und dadurch nur einen für das Vorhandensein der Flamme charakteristischen begrenzten Flackerfrequenzbereich empfängt. Die Schwierigkeit besteht darin, zwischen den im niederfrequenten Bereich liegenden Fremdsignalen mit relativ großen Amplitudenwerten bei Zustand "Flamme aus" und dem darüberliegeneden Frequenzbereich der Nutzsignale mit relativ kleinen Amplitudenwerten bei Zustand "Flamme vorhanden" sicher und eindeutig und mit geringer Ansprechzeit zu unterscheiden.

In bisher bekannten Schaltungsanordnungen, welche über ein optoelektronisches Fühlerelement die Strahlung der Flamme in ein elektrisches Abbildungssignal wandeln und zur Weiterverarbeitung das entsprechend aufbereitete Wechselsignal einer Auswerteeinrichtung zuführen, die das Flammenanwesenheitssignal der Prozeßsteuerung zur Verfügung stellt, werden, wie z.B. aus DE—A—2 413 482 und 2 611 763 hervorgeht, die niederfrequenten Fremdsignale durch in den Signalweg eingefügte spezielle analoge Filter unterdrückt.

Diese Anordnungen haben den Nachteil, daß die mit den Filtern erzielbare Steilheit durch die aus Sicherheitsgründen bestehende Forderung nach kurzen Ansprechzeiten begrenzt und damit der nutzbare Durchlaßbereich eingeschränkt wird, wodurch die Verfügbarkeit der Anlage beeinträchtigt werden kann und die Häufigkeit des Auftretens ungerechtfertiger Störabschaltungen steigt.

Gemäß der Schaltungsanordnung nach DE—A—3 024 013 wird mit Hilfe digitaler Signalverarbeitung ein Flammensignal erzeugt. Dabei werden die vom Fühlerelement aufgenommenen Signale zunächst auf einen Digitalpegel umgesetzt und die Ausgangsimpulse fortwährend gezählt. Aus der Anzahl der Impulse, die in einem ständig mitlaufenden Zeitfenster auftreten, werden Aussagen über das Vorhandensein der Flamme abgeleitet. Als erheblicher Nachteil erweist sich bei dieser Lösung der hohe schaltungstechnische und funktionelle Aufwand für die Bewertung der Signale und für die zusätz-lich erforderlichen Maßnahmen der Eigenüber-wachung des Gesamtsystems zur Gewährlei-stung der Fehlersicherheit.

Hier will die Erfindung Abhilfe schaffen. Die Erfindung, wie sie in den Ansprüchen gekennzeichnet ist, löst die Aufgabe, eine Schaltungsanordnung zur selektiven Flammenüberwachung in Mehrbrenneranlagen für feste, flüssige oder gasförmige Brennstoffe zu schaffen, die mit einfa-chen schaltungstechnischen Mitteln und gerin-gem Bauelementeaufwand höchste Selektivität bei kurzen Ansprechzeiten realisiert, das Auf-treten ungerechtfertiger Störabschaltungen reduziert und damit eine hohe Verfügbarkeit und Sicherheit gegen Flammenvortäuschung garantiert, dadurch, daß der Ausgang des Impulsformers an ein retriggerbares Monoflop und dessen Ausgang an einen Inverter und außerdem an den ersten Eingang eines UND-Gatters angeschlossen ist, und daß in Reihe mit dem Inverter ein weiteres Monoflop geschaltet ist, das mit seinem Aufgang am zweiten Eingang des UND-Gatters liegt, sowie, daß der Ausgang des UND-Gatters mit einem weiteren retriggerbaren Monoflop verbunden ist, das die Schalteinheit ansteuert. Dabei sind zur Erzielung eines gewünschten Durchlaßbereiches der Flackerfrequenz vorzugsweise die Haltezeit des ersten retriggerbaren Monoflops $t_{M10}$ auf die obere Frequenzgrenze des gewünschten Durchlaßbereiches $f_{DO}$ nach der Beziehung

$$t_{M10} = \frac{1}{f_{DO}}$$

und die Haltezeit des weiteren, mit dem Inverter in Reihe geschalteten Monoflops $t_{M20}$ auf die untere Frequenzgrenze des gewünschten Durchlaßbereiches $f_{DU}$ nach der Beziehung

$$t_{M20} = \frac{1}{f_{DU}} - t_{M10}$$

eingestellt.

Die Haltezeit des die Schalteinheit ansteuernden retriggerbaren Monoflops muß größer als die Summe der Haltezeiten der beiden ersten Monoflops und kleiner als die zulässige Abschaltverzögerungszeit eingestellt sein. Nach einer vorteilhaften Ausführungsform wird die gleichzeitige Übertragung von miteinander kombinierten n Frequenzbereichen durch den Einsatz von n Auswerteeinheiten (erstes retriggerbares Monoflop, Inverter, weiteres Monoflop und UND-Gatter) in der Weise erreicht, daß am Ausgang des Impulsformers die parallel geschalteten Eingänge der Auswerteeinheiten liegen und deren n Ausgänge über ein zusätzliches ODER-Gatter an das retriggerbare Monoflop angeschlossen sind, das die Schalteinheit ansteuert.

Eine weitere Verbesserung, deren Anwendung insbesondere in solchen Anlagen zu empfehlen ist, in denen auf Grund der Brenneranordnung der Ausrichtung der Fühlersichtöffnung und anderer anlagenspezifischer Gegebenheiten die Gefahr einer Flammenvortäuschung u.a. darin besteht, daß das optoelektronische Fühlerelement auch von benachbarten Brennerflammen kurzzeitig Signale innerhalb des eingestellten Übertragungsbereiches empfängt, wird dadurch erreicht, daß zwischen dem zweiten retriggerbaren Monoflop und der Schalteinheit ein Integrierglied angeordnet wird. In diesem Fall muß die Haltezeit des zweiten retriggerbaren Monflops kleiner als die Summe der Haltezeiten der beiden ersten Monoflops und größer als die Haltezeit des ersten retriggerbaren Monoflops eingestellt sein. Die Schalteinheit ist dabei als Schwellwertschalter ausgeführt.

Zur Erhöhung der Sicherheit, insbesondere gegen Bauelementeausfall, empfiehlt es sich, die dem Impulsformer folgende Schaltungsanordnung, d.h. die n Auswerteeinheiten, das ODER-Gatter, das zweite retriggerbare Monoflop, das Integrierglied und die Schalteinheit zweifach auszuführen und die Ausgänge konjunktiv zu verknüpfen.

Anschließend soll die erfindungsgemäße Schaltungsanordnung in Funktion beschrieben werden. Die aus dem pulsierenden Anteil der Flammenstrahlung durch das optoelektronische Fühlerelement gewandelten analogen Abbildungssignale oder die noch auf das optoelektronische Fühlerelement eingestrahlten Fremdsignale werden in dem Impulsformer in digitale Signale geformt, deren Impulsfolgefrequenz der Frequenz der aufgenommenen Abbildungssignale entspricht. Die dem Impulsformer folgende Auswerteeinheit, bestehend aus dem retriggerbaren Monoflop, dem Inverter, dem weiteren Monoflop und dem UND-Gatter, stellt ein "Impulsfrequenz-Fenster" dar, welches bewirkt, daß am Ausgang des UND-Gatters jeweils nur dann ein Ausgangsimpuls entsteht, wenn der zeitliche Abstand der L-H-Flanken zweier unmittelbar aufeinander folgender Eingangsimpulse größer als die Haltezeit des retriggerbaren Monoflops und kleiner als die Summe der Haltezeiten der beiden Monoflops ist. Das wird dadurch erreicht, daß die L-H-Flanke des ersten Impulses das retriggerbare Monoflop startet, das nach Ablauf der Haltezeit über den Inverter das zweite Monoflop startet, das während seiner Haltezeit das UND-Gatter offenhält, so daß nur eine in diesen Zeitraum fallende L-H-Flanke des nächstfolgenden Impulses am Ausgang des UND-Gatters erscheint. Die von Impulsformer au das "Impulsfrequenz-Fenster" gelangende Impulsfolge erzeugt nur dann eine frequenzgleiche Impulsfolge am Ausgang des UND-Gatters, wenn die Abbildungssignale innerhalb der eingestellten Frequenzgrenzen liegen.

Die Parallelschaltung mehrerer Auswerteeinheiten ermöglicht die Übertragung eines großen Frequenzbereiches, aus dem die charakteristischen Störfrequenzbereiche absolut ausgeblendet werden. Die Ausgangsimpulsfolge wird mit Hilfe des zweiten retriggerbaren Monoflops in das Flammenanwesenheitssignal umgewandelt, welches an den Eingang der Schalteinheit gelangt, die die Prozeßsteuerung übernimmt. Durch eine zusätzliche Integration des Flammenanwesenheitssignals und Festlegung einer Schaltschwelle für die Schalteinheit wird ein Auslösen der Schalteinheit bei erloschener Flamme durch kurze Impulseinstreuungen vereinzelter Fremdsignale benachbarter Brennerflammen vermieden. Frequenzen des aufgenommenen Flammensignals aus der zugehörigen Brennerflamme, deren Periodendauer kleiner ist als die Haltezeit $t_{M30}$, bewirken eine ständige Nachtriggerung des zweiten retriggerbaren Monoflops. Flammensignale mit tieferen Frequenzen (jedoch innerhalb des Übertragungsbereiches) erscheinen unverändert am Ausgang des zweiten retriggerbaren Monoflops und werden mittels des folgenden Integrierfliedes in eine pulsierende Gleichspannung umgeformt, die ständig über der Schaltschwelle der Schalteinheit bleibt.

Durch die Erfindung wird somit eine Schaltungsanordnung zur selektiven Flammenüberwachung in Mehrbrenneranlagen bereitgestellt, die nach dem Wechselstrahlungsprinzip arbeitet und die einen für die Selektierung von Flammen erforderlichen Nutzsignal-Auswertebereich mit einer vorgegebenen Frequenzbegrenzung überträgt und die außerhalb dieser Grenzen auftretenden Fremdsignale unabhängig von ihrer Amplitudengröße absolut sperrt. Dabei finden einfache Mittel der Digitaltechnik Anwendung, die eine Einzelimpulsbewertung ermöglichen und Zählschaltungen sowie die Anwendung von Mikroprozessoren vermeiden. Die erforderlichen Durchlaßbereiche werden mit einer beliebig bestimmbaren oberen und unteren Frequenzbegrenzung (z.B. 60 Hz . . . 90 Hz, 130 Hz . . . 150 Hz, 200 Hz . . .300 Hz etc.) einzeln bzw. miteinander kombinierbar übertragen.

Im folgenden wird die Erfindung anhand von zwei Ausführungs beispielen unter bezug auf die Zeichnungen näher erläutert. Es zeigen:

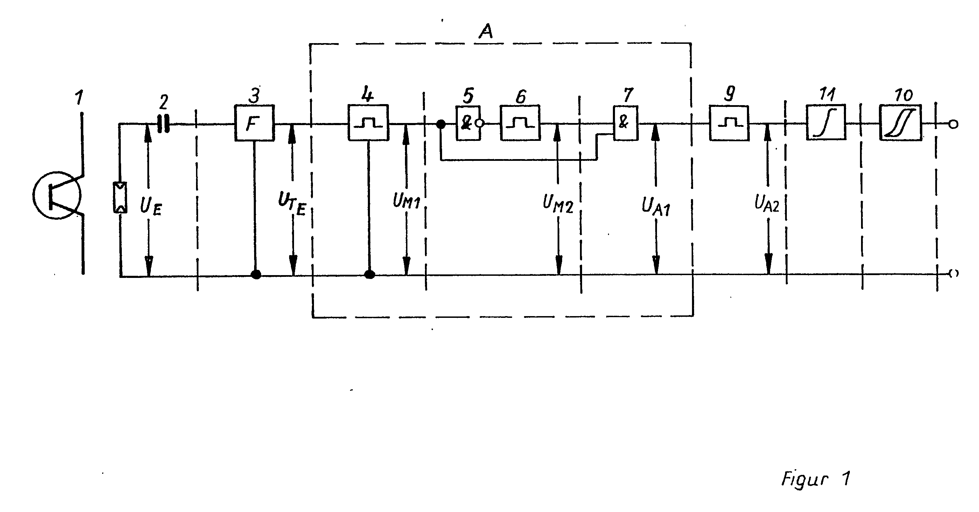

Figur 1 ein Prinzipschaltbild einer Schaltungsanordnung zur Übertragung eines Frequenzbereiches,

Figur 2 ein Prinzipschaltbild einer Schaltungsanordnung zur Übertragung von n Frequenzbereichen,

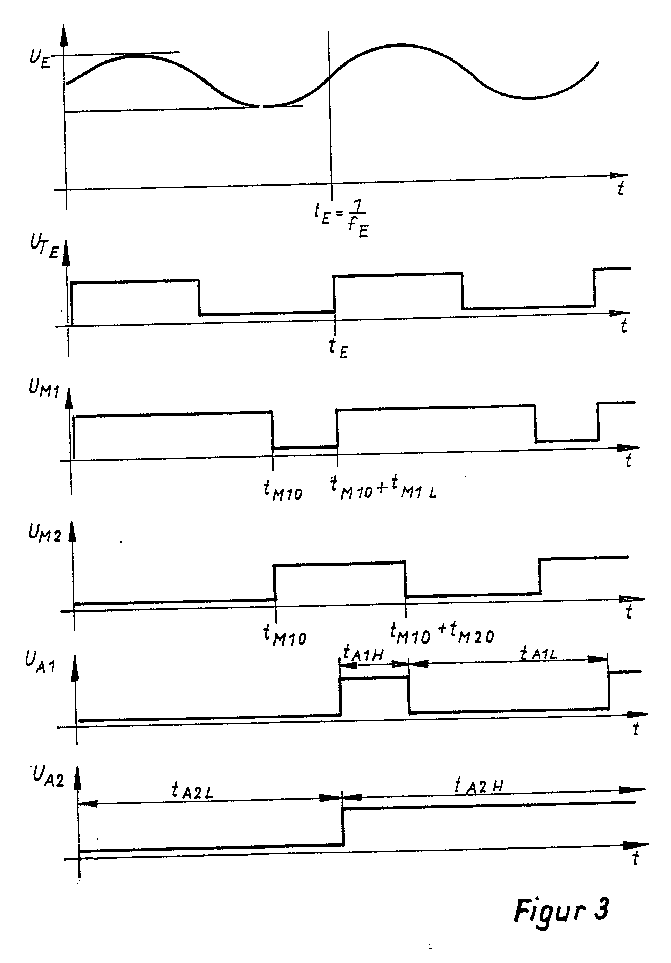

Figur 3 ein Impulsdiagram für eine in den Durchlaßbereich fallende Frequenz der Eingangssignalspannung,

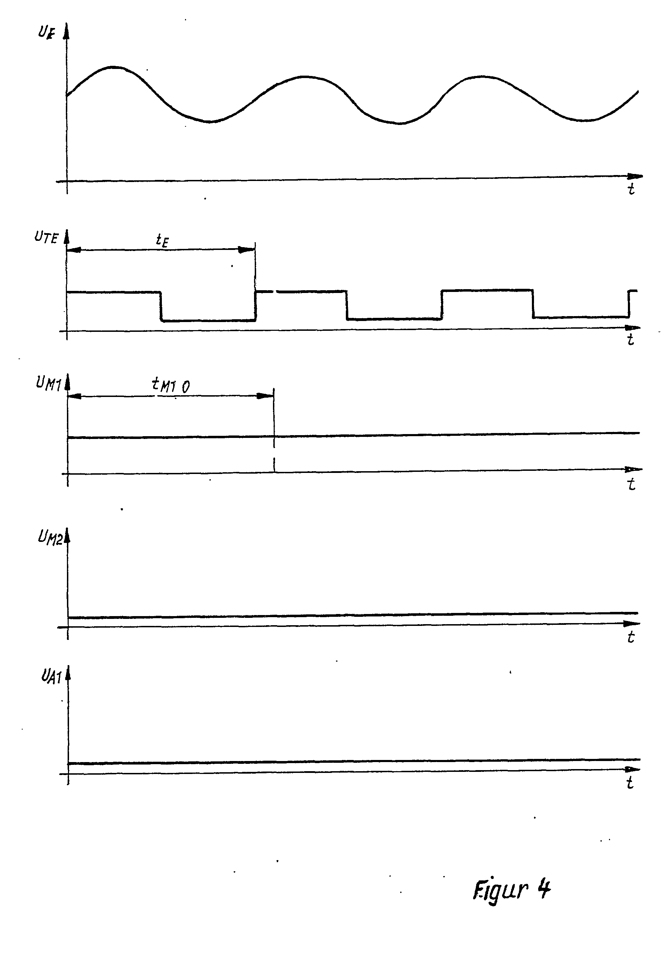

Figur 4 ein Impulsdiagramm für eine Eingangssignalspannung, deren Frequenz über dem Durchlaßbereich liegt, und

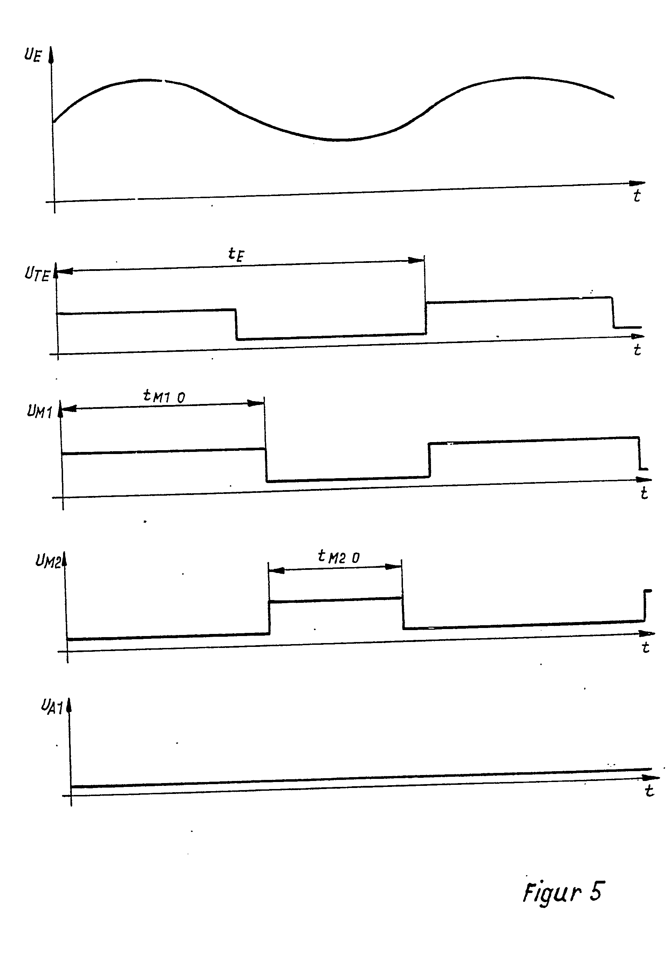

Figur 5 ein Impulsdiagramm für eine Eingangssignalspannung, deren Frequenz unter dem Durchlaßbereich liegt.

Für die weitere Betrachtung wird angenommen, daß die Abbildungs-Signalspannung, also die Eingangs-Signalspannung $U_E$, und deren Frequenz $f_E$ in einem kurzen Zeitabschnitt periodisch verlaufen.

Die Wirkungsweise der erfindungsgemäßen Schaltungsanordnung ist folgende:

Das optoelektronische Fühlerelement 1 ist über eine Sichtöffnung an der Feuerungsanlage auf die Brennerflamme, vorzugsweise auf den Flammenkern, gerichtet und wandelt deren Strahlung in eine elektrische Abbildungs-Signalspannung, die aus einer Gleichspannung besteht, der eine Wechselsignalspannung mit der Frequenz $f_E$ überlagert ist. Über den Kondensator 2 wird nur die Wechselsignalspannung weitergeleitet und in dem folgenden Impulsformer (F) 3 in eine entsprechende Rechtecksignalspannung $U_{TE}$ mit der Periodendauer

$$t_E = \frac{1}{f_E}$$

geformt.

Mit der L-H-Flanke der Rechtecksignalspannung $U_{TE}$ wird das retriggerbare Monoflop 4 gesetzt, d.h. die Ausgangsspannung $U_{M1}$ wird auf H-Pegel gesetzt. Im folgenden wird zunächst davon ausgegangen, daß eine Brennerflamme vorhanden ist und für den Durchlaßfrequenzbereich charakteristische Werte (z.B. $f_{DU} = 60$ Hz, $f_{DO} = 90$ Hz) gewählt wurden, so daß $f_{DU} < f_E < f_{DO}$ gilt, wobei $f_{DU}$ und $f_{DO}$ die untere bzw. obere Frequenzgrenze des Übertragungsbereiches sind. Die Haltezeit $t_{M10}$ des retriggerbaren Monoflops 4 ist auf

$$t_{M10} = \frac{1}{f_{DO}}$$

und die Haltezeit des Monoflops 6 auf

$$t_{M20} = \frac{1}{f_{DU}} t_{M10}$$

eingestellt.

Da aufgrund der Bedingung $f_E < f_{DO}$ die Haltezeit $t_{M10} < t_E$ ist, kippt zum Zeitpunkt $t_{M10}$ die Ausgangsspannung $U_{M1}$ auf L-Pegel zurück und wird zum Zeitpunkt $t_E$ (folgende L-H-Flanke) wieder auf H-Pegel gesetzt, usw. Die Ausgangsspannung $U_{M1}$ hat also einen zeitlichen Pegelverlauf von:

$$t_{M1H} = t_{M10} \text{ und}$$
$$t_{M1L} = t_E - t_{M10}$$

usw., wobei $t_{M1H}$ die Zeitdauer des H-Pegels und $t_{M1L}$ die Zeitdauer des L-Pegels von $U_{M1}$ bedeuten.

Die Ausgangsspannung $U_{M1}$ wird über den Inverter 5 an den Eingang des Monoflops 6 und außerdem an den ersten Eingang des UND-Gatters 7 geführt. Mit der H-L-Flanke der Ausgangsspannung $U_{M1}$, die zum Zeitpunkt $t_{M10}$ auftritt, wird das Monoflop 6 gesetzt, so daß dessen Ausgangsspannung $U_{M2}$ H-Potential annimmt. Die Ausgangsspannung $U_{M2}$ kippt dann nach Ablauf der Haltezeit $t_{M20}$ auf L-Pegel zurück und wird nach einem weiteren Zeitablauf von $t_E - t_{M20}$ (folgende H-L-Flanke von $U_{M1}$) wieder auf H-Pegel gesetzt, usw.. Die Ausgangsspannung $U_{M2}$ hat also einen zeitlichen Pegelverlauf von:

$$t_{M2H} = t_{M20} \text{ und}$$
$$t_{M2L} = t_E - t_{M20}$$

usw., wobei $t_{M2H}$ die Zeitdauer des H-Pegels und $t_{M2L}$ die Zeitdauer des L-Pegels von $U_{M2}$ bedeuten.

Da bei vorhandener Brennerflamme auch die Bedingung $f_E < f_{DU}$, d.h. $t_E < t_{M10} + t_{M20}$, erfüllt ist, liegen die Ausgangsspannungen $U_{M1}$ und $U_{M2}$, also die beiden Eingänge des UND-Gatters 7, vom Zeitpunkt $t_E$ bis $t_{M10} + t_{M20}$ gleichzeitig auf H-Pegel, der dann auch am Ausgang des UND-Gatters 7 ansteht. Die Ausgangsspannung $U_{A1}$ des UND-Gatters 7 fällt zum Zeitpunkt $t_{M10} + t_{M20}$ auf L-Pegel zurück und wird nach einem weiteren Zeitablauf von $t_E - (t_{M10} + t_{M20})$ wieder auf H-Pegel gesetzt.

Die Ausgangsspannung $U_{A1}$ hat also einen zeitlichen Pegelverlauf von

$$t_{A1H} = (t_{M10} + t_{M20}) - t_E \text{ und}$$
$$t_{A1L} = t_E - t_{A1H}$$

usw., wobei $t_{A1H}$ die Zeitdauer des H-Pegels und $t_{A1L}$ die Zeitdauer des L-Pegels der Ausgangsspannung $U_{A1}$ bedeuten.

Mit der L-H-Flanke der Ausgangsspannung $U_{A1}$ wird das folgende retriggerbare Monoflop 9 gesetzt, d.h. dessen Ausgangsspannung $U_{A2}$ auf H-Pegel gesetzt. Die Haltezeit $t_{M30}$ des retriggerbaren Monoflops 9 ist in Abhängigkeit von der Brenneranordnung, der Ausrichtung der Fühlersichtöffnung und anderer anlagenspezifischer Gegebenheiten auf die untere Frequenzgrenze des Durchlaßbereiches $f_{DU}$ nach der Beziehung

$$t_{M30} = \frac{1}{f_{DU}}$$

eingestellt.

Durch die L-H-Flanken der Ausgangsspannung $U_{A1}$ des UND-Gatters 7 erfolgt eine ständige Nachtriggerung des Monoflops 9, so daß an dessen Ausgang der H-Pegel der Ausgangsspannung $U_{A2}$ (Flammenanwesenheitssignal) erhalten bleibt und durch die Schalteinheit 10 der Steuerbefehl "Flamme vorhanden" ausgegeben wird. Bei Ausfall der Brennerflamme werden vom optoelektronischen Fühlerelement 1 Fremdsignale aus der Hintergrundstrahlung bzw. aus der Einstrahlung benachbarter Flammenspitzen aufgenommen, deren Frequenz $f_E$ außerhalb der Übertragungsbereiches der aus dem retriggerbaren Monoflop 4, dem Inverter 5, dem Monoflop 6 und aus dem UND-Gatter 7 bestehenden Auswerteeinheit liegt, so daß eine Fallunterscheidung vorzunehmen ist für Fremdsignale unterhalb und oberhalb des Übertragungsbereiches. Für aufgenommene Signalspannungen, deren Frequenz $f_E$ größer als die obere Frequenzgrenze $f_{DO}$ der Übertragungsbereiches ist, gilt, daß die Haltezeit $t_{M10}$ des retriggerbaren Monoflops 4 größer ist als die Periodendauer $t_E$ der Eingangssignalspannung, so daß eine ständige Nachtriggerung des Monoflops 4 vor Ablauf seiner Haltezeit erfolgt und das Monoflop 6 über den Inverter 5 nicht gestartet werden kann. Da somit am UND-Gatter 7 unterschiedliche Signalpegel anliegen, wird das Monoflop 9 nicht mehr nachgetriggert, wodurch nach Ablauf der Haltezeit $t_{M20}$ und Abfall der Ausgangsspannung des Integriergliedes 11 unter die Schwellspannung des Schwellwertschalters 10 der Steuerbefehl "Flamme aus" ausgegeben wird. Für aufgenommene Fremdsignale, deren Frequenz $f_E$ kleiner als die untere Frequenzgrenze $f_{DU}$ des Übertragungsbereiches ist, gilt, daß die Periodendauer $t_E$ der Eingagssignalspannung größer ist als die Summe der Haltezeiten der Monoflops 4 und 6, so daß das periodische Starten des retriggerbaren Monoflops 4 jeweils erst dann erfolgt, wenn die Haltezeit $t_{M20}$ des Monoflops 6 bereits abgelaufen ist. Damit liegen die beiden Eingänge des UND-Gatters 7 folglich nie gleichzeitig auf H-Potential, wodurch die Schalteinheit 10 kein Flammenanwesenheitssignal mehr erhält. Bei Ausfall der Brennerflamme werden vom optoelektronischen Fühlerelement 1 außer der bereits erwähnten, außerhalb des Übertragungsbereiches der Anordnung liegenden Strahlung in Abhängigkeit von den spezifischen Gegebenheiten der Anlage u.U. kurzzeitig auch Signale benachbarter Brennerflammen aufgenommen, deren Frequenz innerhalb des Übertragungsbereiches liegen kann. Diese Störungen gelangen über den Signalweg an den Eingang des Integriergliedes 11 und werden von diesem in eine pulsierende Gleichspannung umgeformt, die ständig unter dem Schwellwert des Schwellwertschalters 10 bleibt.

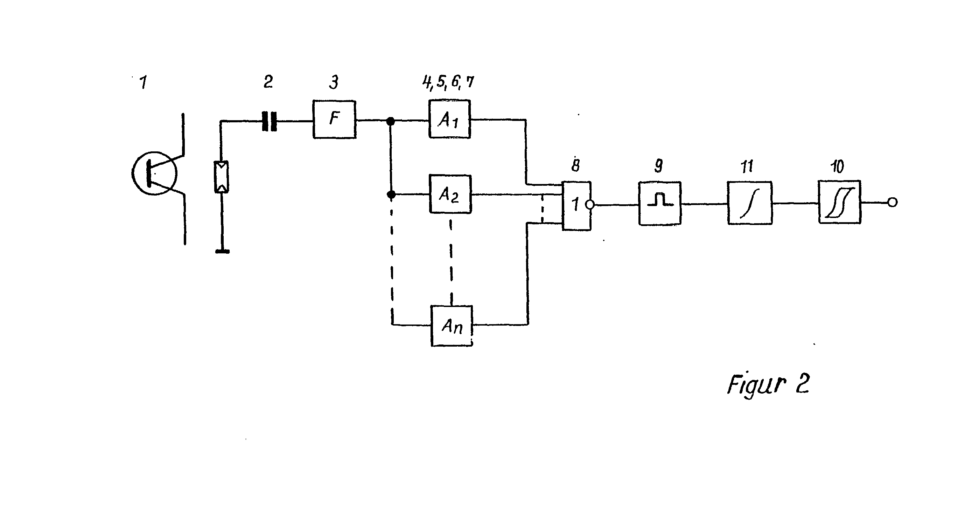

Die Übertragung mehrerer charakteristischer Frequenzbereiche durch Parallelschaltung mehrerer Auswerteeinheiten $A_1 \ldots A_n$ gemäß Figur 2 hat den Vorteil, daß die Schaltungsanordnung eine vorhandene Brennerflamme mit hoher Sicherheit auch dann als solche erkennt, wenn diese Schwankungen der Flammenqualität etwa infolge von Regelungsprozessen aufweist. Weiterhin wird durch die durchgängige digitale Signalverarbeitung eine hohe Selektivität bei kurzer Ansprechzeit erreicht, indem bekannte brenner- und verbrennungsraumtypische Störfrequenzbereiche, die zu einer Flammenvortäuschung führen könnten, aus dem zu übertragenden Frequenzband durch Einzelimpulsbewertung verzögerungsfrei und absolut eliminiert können. Die erfindungsgemäße Schaltungsanordnung hat darüber hinaus den Vorzug, kostengünstig zu sein und dabei ein hohes Maß an Eigensicherheit zu realisieren.

**Patentansprüche**

1. Schaltungsanordnung zur selektiven Flammenüberwachung in Mehrbrenneranlagen, bestehend aus einer optoelektronischen Fühlereinheit, bei der das optoelektronische Fühlerelement (1) über einen Kondensator (2) mit einem Impulsformer (3), der eine der Flackerfrequenz der Flamme entsprechende Impulsfolge erzeugt verbunden ist, und einer elektronischen Auswerte- und Schalteinheit, dadurch gekennzeichnet, daß der Ausgang des Impulsformers (3) an ein retriggerbares Monoflop (4) und dessen Ausgang an einen Inverter (5) und außerdem an den ersten Eingang eines UND-Gatters (7) angeschlossen und in Reihe mit dem Inverter (5) ein weiteres Monoflop (6) geschaltet ist, das mit seinem Ausgang am zweiten Eingang des UND-Gatters (7) liegt, und der Ausgang des UND-Gatters (7) mit einem weiteren retriggerbaren Monoflop (9) verbunden ist, das die Schalteinheit (10) ansteuert.

2. Schaltungsanordnung nach Anspruch 1, bei der zur Erzielung eines gewünschten Durchlaßbereiches der Flackerfrequenz vorzugsweise die Haltezeit $t_{M10}$ des ersten retriggerbaren Monoflops (4) auf die obere Frequenzgrenze $f_{DO}$ des gewünschten Durchlaßfrequenzbereiches nach der Beziehung $t_{M10} = 1/f_{DO}$ und die Haltezeit $t_{M20}$ des Monoflops (6) auf die untere Frequenzgrenze $f_{DU}$ des gewünschten Durchlaßfrequenzbereichs nach der Beziehung $t_{M20} = 1/f_{DU} - t_{M10}$ eingestellt sind.

3. Schaltungsanordnung oder nach Anspruch 1 oder 2, bei der die aus dem retriggerbaren Monoflop (4), dem Inverter (5), dem Monoflop (6) und aus dem UND-Gatter (7) bestehende Auswerteeinheit (A) mehrfach vorhanden ist, wobei die Eingänge der jeweiligen retriggerbaren Monoflops (4) parallel geschaltet und die Ausgänge der jeweiligen UND-Gatter (7) über ein ODER-Gatter (8) an den Eingang des retriggerbaren Monoflops (9) geführt sind (Fig. 2).

4. Schaltungsanordnung nach einem der Ansprüche 1 bis 3, bei der die Haltezeit des retriggerbaren Monoflops (9) größer als die Summe der Haltezeiten der Monoflops (4) und (6) und kleiner als die zulässige Abschaltverzögerungszeit eingestellt ist.

5. Schaltungsanordnung nach einem der Ansprüche 1 bis 3, bei der die Haltezeit des retriggerbaren Monoflops (9) kleiner als die Summe der Haltezeiten des retriggerbaren Monoflops (4) und des Monoflops (6) un größer als die Haltezeit des retriggerbaren Monoflops (4) eingestellt ist und zwischen dem retriggerbaren Monoflop (9) und der Schalteinheit (10) ein Integrierglied (11) angeordnet ist, wobei die Schalteinheit (10) als Schwellwertschalter ausgeführt ist.

6. Schaltungsanordnung nach einem der Ansprüche 1 bis 5, bei der die dem Impulsformer (3) folgende Schaltungsanordnung zweifach vorhanden ist und die Ausgänge konjunktiv verknüpft sind.

## Revendications

1. Circuit pour la surveillance sélective de flammes d'installations à brûleurs multiples, comprenant une unité de détection opto-électronique, dans laquelle l'élément capteur opto-électronique (1) est relié, par un condensateur (2), à un formateur d'impulsions (3) qui produit une série d'impulsions correspondant à la fréquence de scintillement de la flamme, et à une unité de commutation et d'exploitation électronique, caractérisé en ce que la sortie du formateur d'impulsions (3) est reliée à un déclencheur à bascule (4) et sa sortie à un inverseur (5) et, en outre à la première entrée d'un grille ET (7), et en série avec l'inverseur (5), est branché un autre déclencheur à bascule (6) dont sa sortie se trouve à la deuxième entrée de la grille ET (7), et la sortie de la grille ET (7) est reliée avec un autre déclencheur à bascule (9) qui commande l'unité de commutation (10).

2. Circuit selon la revendication 1, dans lequel pour obtenir une bande de transmission souhaitée de la basse fréquence, le temps d'arrêt $t_{m10}$ de la première bascule susceptible de se déclencher (4) est réglée sur la fréquence de coupure supérieure $f_{DO}$ de la bande de fréquence de transmission souhaitée selon la relation $t_{M10} = 1/f_{DO}$ et le temps d'arrêt $t_{M20}$ du déclencher à bascule (6) est réglé sur la fréquence de coupure inférieure $f_{DU}$ de la band de fréquence de transmission souhaitée selon la relation $t_{M20} = 1/f_{DU} - t_{M10}$.

3. Circuit selon la revendication 1 ou 2, dans lequel l'unité d'exploitation (A) composée du déclencheur à bascule (4), de l'inverseur (5) du déclencheur à bascule (6) et de la grille ET (7) existe plusieurs fois, les entrées des bascules susceptible de se déclencher (4) respectives étant branchées en parallèle et les sorties des grilles ET (7) respectives étant amenées par une grille OU à l'entrée du déclencheur à bascule (9) (figure 2).

4. Circuit selon l'une des revendications 1 à 3, dans lequel le temps d'arrêt de la bascule (9) est réglé plus grande que la somme des temps d'arrêt des bascules (4) et (6), mais plus petit que le temps de retard de rupture admissible.

5. Circuit selon l'une des revendications 1 à 3, dans lequel le temps d'arrêt du déclencheur à bascule (9) est ajusté plus petit que la somme des temps d'arrêt des bascules (4) et (6) et plus grand que le temps d'arrêt de la bascule (4) et un intégrateur (11) est disposé entre la bascule (9) et l'unité de commutation (10), l'unité de commutation étant réalisée comme interrupteur de valeur seuil.

6. Circuit selon l'une des revendications 1 à 5, dans lequel le circuit à la suite de formateur d'impulsions (3) existe en double et les sorties sont connectées opérationnellement.

## Claims

1. Circuit arrangement for the selective flame monitoring in multiple burner installations, consisting of an optoelectronic sensor unit wherein the optoelectronic sensor element (1) is connected to a pulse shaper (3) via a capacitor (2), said pulse shaper generating a pulse train corresponding to the flickering frequency of the flame, and to an electronic evaluation and switching unit, characterized in that the output of the pulse shaper (3) is connected to a retriggerable monostable circuit (4) and its output is connected to an inverter (5) and in addition to the first input of an AND element (7), and in that in series with the inverter (5) a further monostable circuit (6) is connected whose output is applied to the second input of the AND element (7), and in that the output of the AND circuit (7) is connected to a further regriggerable monostable circuit (9) driving the switching unit (10).

2. The circuit arrangement according to claim 1, wherein, in order to ensure a desired transmission range of the flickering frequency, the hold time $t_{M10}$ of the first retriggerable monostable circuit (4) is set at the upper frequency boundary $f_{DO}$ of the desired transmission frequency range in accordance with the relation $t_{M10} = 1/f_{DO}$, and wherein the hold time $t_{M20}$ of the monostable circuit (6) is set at the lower frequency boundary $f_{DU}$ of the desired transmission frequency range in accordance with the relation $t_{M20} = 1/f_{DU} - t_{M10}$.

3. The circuit arrangement according to claim 1 or claim 2, wherein the evaluation unit (A) consisting of the retriggerable monostable circuit (4), the inverter (5), the monostable circuit (6) and the AND element (7) is provided a plurality of times, with the inputs of the respective retriggerable monostable circuits (4) being connected in parallel and the outputs of the respective AND circuit (7) being connected to the input of the retriggerable monostable circuit (9) via an OR element (8) (Fig. 2).

4. The circuit arrangement according to one of claims 1 to 3, wherein the hold time of the retriggerable monostable circuit (9) is set to be greater than the sum of the hold times of the monostable circuits (4) and (6) and smaller than the permissible turnoff delay time.

5. The circuit arrangement according to one of claims 1 to 3, wherein the hold time of the retriggerable monostable circuit (9) is set to be smaller than the sum of the hold times of the retriggerable monostable circuit (4) and the monostable circuit (6) and greater than the hold-time of the retgriggerable monostable circuit (4), and wherein between the retriggerable monostable circuit (9) and the switching unit (10) an integrator (11) is provided, with the switching unit (10) being designed as a threshold switch.

6. The circuit arrangement according to one of claims 1 to 5, wherein the circuit arrangement following the pulse shaper (3) is provided twice and the outputs are connected for AND operation.

Figur 1

Figur 2

Figur 3

Figur 4

4

Figur 5